# DEMANDE DE BREVET EUROPEEN

(11) **EP 1 225 637 A1**
(43) Date de publication de la demande: **24.07.2002**
(21) Numéro de dépôt: 02290039.3
(22) Date de dépôt: 09.01.2002
(51) Int. Cl.: H01L 27/144, H01L 27/146

(54) **Circuit intégré comportant un dispositif semiconducteur de type photodiode, et procédé de fabrication**

(30) Priorité: 12.01.2001 FR 0100420
(71) Demandeur: STMicroelectronics S.A., 92120 Montrouge (FR)
(72) Inventeur: Menut, Olivier, 38000 Grenoble (FR); Gris, Yvon, 38210 Tullins (FR)
(74) Mandataire: Casalonga, Axel

(57) **Abrégé**

Le circuit intégré comprend un substrat SB incorporant un dispositif semiconducteur du type photodiode comportant une jonction P/N. Le dispositif comporte une tranchée capacitive TRC enterrée dans le substrat et connectée en parallèle avec ladite jonction

## Description

L'invention concerne les circuits intégrés, et plus particulièrement les dispositifs semiconducteurs de type photodiode.

La réalisation d'une bonne photodiode est délicate. En effet il faut qu'elle soit sensible à la lumière, et seule la zone de charge d'espace de la jonction est susceptible de collecter les porteurs générés par l'excitation lumineuse, en raison du champ électrique existant dans cette zone.

Or la photodiode est d'autant plus sensible que la zone de charge d'espace est grande. Ceci implique que le gradient de dopage au niveau de la jonction soit faible.

Mais si le gradient de dopage est faible, la valeur capacitive de la jonction est également faible. Or le rôle d'une photodiode est de stocker les porteurs générés dans la zone de charge d'espace, dans cette capacité de jonction.

La solution habituellement utilisée consiste à augmenter le gradient de dopage de la jonction ainsi que la tension appliquée à cette jonction. On peut ainsi obtenir une large zone de charge d'espace associée à une forte capacité de jonction. Typiquement, il faut appliquer une tension supérieure à 5 volts si les dopages sont importants.

Mais les circuits intégrés submicroniques actuels ne permettent pas d'utiliser de fortes tensions. En effet pour ces technologies, la tension d'alimentation maximale est inférieure à 3,3 volts.

L'invention vise à apporter une solution à ce problème.

Un but de l'invention est de décorréler le gradient de dopage de la jonction vis-à-vis de la capacité de cette jonction.

L'invention a encore pour but de diminuer le gradient de dopage au niveau de la jonction de façon à obtenir une forte extension de la zone de charge d'espace même pour des tensions appliquées faibles.

L'invention a encore pour but d'augmenter la capacité associée à la jonction, tout en n'augmentant pas l'encombrement surfacique et en ne diminuant pas la sensibilité de la photodiode pour une surface donnée.

L'invention propose donc un circuit intégré, comprenant un substrat incorporant un dispositif semiconducteur du type photodiode comportant une jonction P/N. Selon une caractéristique générale de l'invention, le dispositif comporte une tranchée capacitive enterrée dans le substrat et connectée en parallèle avec ladite jonction.

La jonction présente avantageusement un faible niveau de dopage ou bien un faible gradient de dopage, de telle façon que la longueur de la zone de charge d'espace est supérieure à 1 micron même pour des faibles tensions en inverse, par exemple inférieures à 1 volt. Ceci est réalisé par exemple par un dopage inférieur à 10¹⁵ at/cm3 dans le cas d'une jonction abrupte à faible dopage d'un seul côté ou bien par un gradient de dopage inférieur à 10²⁰ at/cm⁴ dans le cas d'une jonction à dopage linéaire.

Par ailleurs ce paramètre est décorrélé du paramètre capacité.

A cet égard, la capacité associée à la jonction est augmentée grâce à la présence de la tranchée capacitive enterrée, et ce sans augmentation de surface de la photodiode ni perte de sensibilité.

Selon un mode de réalisation, le substrat est formé de silicium, et la tranchée capacitive comporte une zone interne de silicium dopé, partiellement enveloppée d'une paroi isolante séparant latéralement ladite zone interne du substrat, et surmontée d'une zone supérieure de silicium dopé, cette zone supérieure étant en contact avec ladite jonction.

Selon un mode de réalisation, le substrat comporte une partie inférieure fortement dopée avec une conductivité de type P, de préférence avec une concentration de dopants supérieure à 10¹⁸ at/cm³ et par exemple avec une concentration de dopants égale à 10¹⁹ at/cm³. Le substrat comporte également une partie supérieure de conductivité P, moins dopée que la partie inférieure. La zone interne et la zone supérieure de la tranchée capacitive ont une conductivité de type N, et la région de la jonction ayant la conductivité de type N, comporte une zone inférieure de conductivité N en contact avec la zone supérieure de la tranchée, et une zone supérieure de conductivité N mais plus fortement dopée que la zone inférieure.

L'utilisation d'un substrat de type P fortement dopé n'est pas obligatoire mais permet de diminuer les résistances d'accès et le bruit.

Les procédés de fabrication des composants semiconducteurs peuvent détruire la continuité cristalline de la surface d'une partie du substrat initial semiconducteur monocristallin. C'est notamment le cas lors de la réalisation d'une tranchée. Le substrat semiconducteur présente, à l'endroit de la tranchée, un matériau différent sans structure cristalline. En conséquence la surface de la partie du substrat occupée par la tranchée, est inutilisable pour réaliser des dispositifs semiconducteurs.

L'invention permet également d'apporter une solution à ce problème.

Un but de l'invention est de permettre la réalisation d'un substrat moncristallin autorisant la formation ultérieure d'une couche épitaxiale de silicium exempte de défauts cristallins et dans laquelle on réalisera la jonction.
L'invention propose donc également un procédé de fabrication d'un circuit intégré comprenant un substrat incorporant un dispositif semiconducteur du type photodiode comportant une jonction P/N, Selon une caractéristique générale de l'invention,
a) on élabore un substrat initial monocristallin présentant localement une tranchée capacitive débouchant à la surface du substrat initial et formant une discontinuité du réseau cristallin,
b) on évide le substrat initial au niveau de la tranchée,
c) on amorphise le réseau cristallin en périphérie de l'évidemment,
d) on dépose sur la structure obtenue à l'étape précédente une couche de matière amorphe ayant la même composition chimique que celle du substrat initial,
e) on effectue un recuit thermique de la structure obtenue à l'étape précédente afin de recristalliser la matière amorphe en continuité avec le réseau monocristallin du substrat initial,
f) on fait croître par épitaxie une couche supérieure de substrat dans laquelle on réalise ladite jonction connectée en parallèle avec ladite tranchée capacitive.

Selon un mode de mise en oeuvre, le procédé comprend, préalablement ou postérieurement à l'étape e), une étape d'aplanissement de surface, par exemple un polissage mécano-chimique.

La formation de la jonction comporte de préférence une co-diffusion de surface de type N⁺ avec de l'arsenic et du phosphore afin de diminuer le gradient de dopage de la jonction.

Selon un mode de mise en oeuvre, l'étape d'amorphisation comporte une implantation ionique localisée autour de l'évidemment par une opération de masquage.

Selon un mode de mise en oeuvre, dans l'étape a), on dépose successivement sur le substrat initial une première couche d'un premier matériau et une deuxième couche d'un deuxième matériau, puis on grave une tranchée que l'on remplit avec un matériau de remplissage,
et dans l'étape b), on effectue une gravure sélective vis-à-vis de ladite deuxième couche, de la première couche et d'une partie supérieure du matériau de remplissage de la tranchée, de façon à former des cavités latérales et ledit évidemment au niveau de la discontinuité cristalline, et on retire ladite deuxième couche .

Dans l'étape a), le remplissage de la tranchée comprend avantageusement les étapes suivantes :
- on tapisse les parois de la tranchée avec de l'oxyde par oxydation thermique ;
- on dépose du silicium polycristallin fortement dopé dans la tranchée de manière à la remplir ;
- on grave le silicium polycristallin déposé précédemment de manière à ce que le niveau de remplissage de la tranchée soit en dessous de la surface du substrat initial.

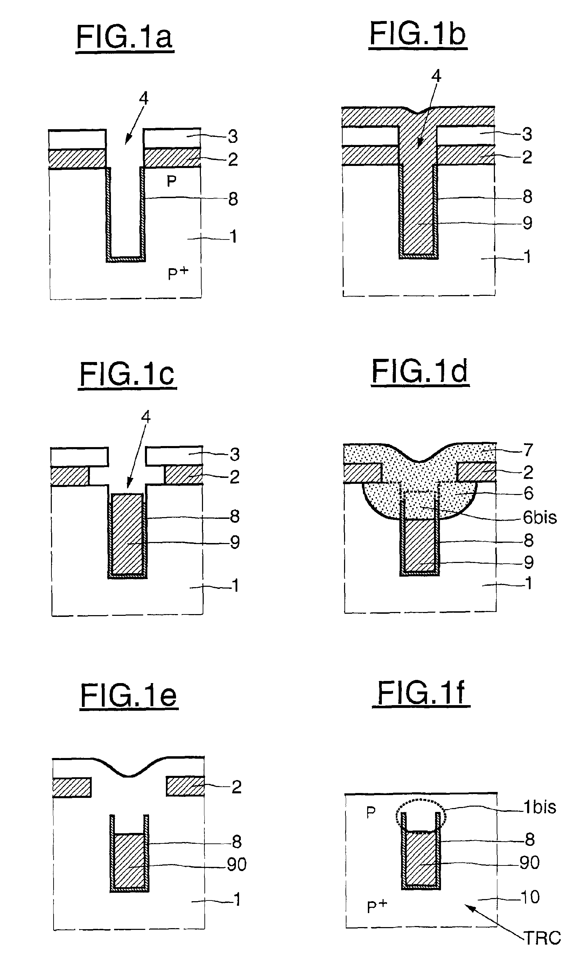

D'autres avantages et caractéristique de l'invention apparaîtront à l'examen de la description détaillée de modes de réalisation et de mise en oeuvre, nullement limitatifs, et des dessins annexés sur lesquels les figures 1a à 1h illustrent schématiquement les principales étapes d'un procédé selon l'invention ainsi qu'un mode de réalisation d'une photodiode selon l'invention.

Le substrat de départ du procédé de l'invention, ou substrat initial, est illustré sur la figure la et comporte ici une tranchée. Le substrat initial 1 comporte une partie inférieure dopée P⁺, avec une concentration de dopants égale à 10¹⁹ at/cm³, et une partie supérieure épitaxiée sur la partie inférieure et dopée P avec une concentration de 5.10¹⁴ at/cm³. La tranchée peut être réalisée, selon une mise en oeuvre du procédé de l'invention, par dépôt dans un premier temps d'une couche d'oxyde de silicium 2 sur le substrat initial en silicium monocristallin 1. L'épaisseur de cette couche 2 peut varier entre 0,01 micron et 1 micron, et est de préférence de l'ordre de 2000 Å.

On dépose ensuite sur l'oxyde 2 une couche de nitrure de silicium 3. L'épaisseur de cette couche 3 peut également varier entre 0,01 micron et 1 micron, et est également de préférence de l'ordre de 2000 Å.

On grave ensuite, de manière classique, tout d'abord le nitrure 3 et l'oxyde 2, puis finalement le silicium monocristallin du substrat 1 à l'aide d'une opération de photo-lithographie, pour former la tranchée 4.

La tranchée 4 a une profondeur d'environ 10µm et une largeur variable, de préférence inférieure à 1µm.

On effectue ensuite une oxydation thermique contrôlée de manière à déposer sur les parois de la tranchée 4 une couche d'oxyde de silicium 8 d'épaisseur comprise entre 40 et 1000 Å, de préférence entre 50 et 300 Å. on obtient le dispositif illustré à la figure 1a.

On dépose ensuite sur la plaquette et de manière à remplir la tranchée 4, du silicium polycristallin 9 fortement dopé N⁺. Le dopage du silicium est réalisé in situ.

On obtient un dispositif tel qu'illustré à la figure 1b.

On grave ensuite le silicium polycristallin 9, déposé précédemment, au moins de manière à le retirer de la surface de la plaquette. Par ailleurs, cette gravure est menée jusqu'à ce que le niveau du silicium polycristallin dans la tranchée 4 soit en dessous de la surface du substrat initial 1.

L'étape suivante consiste en une désoxydation contrôlée, essentiellement de manière à former sous la couche de nitrure de silicium 3 deux cavités latérales de largeur donnée dans la couche d'oxyde 2 comme l'illustre la figure 1c. On retire également une partie de l'oxyde de silicium 8 dans la tranchée 4.

Cette désoxydation s'effectue par gravure isotrope à l'acide fluorhydrique ou encore par gravure plasma isotrope au fluor. On obtient alors le dispositif illustré à la figure 1c sur laquelle la tranchée est tapissée d'une couche d'oxyde de silicium 8 dont la hauteur est inférieure à la hauteur de la couche de silicium polycristallin dopé 9 dans la tranchée 4. Deux cavités latérales de largeur donnée apparaissent sous la couche de nitrure de silicium 3 et dans la couche d'oxyde de silicium 2.

On retire ensuite de manière classique le masque de nitrure de silicium 3.

On amorphise ensuite le silicium découvert,

Le silicium découvert à ce stade du procédé est le silicium monocristallin du substrat 1, ainsi que la partie émergente de silicium polycristallin dopé 9 dans la tranchée 4. On crée ainsi des zones de silicium amorphe référencées 6 et 6bis (figure 1d).

L'amorphisation simultanée localisée des régions 6 et 6bis est auto-alignée sur la tranchée. L'amorphisation s'effectue de manière classique par destruction du réseau cristallin du silicium et du silicium polycristallin 6bis, par exemple par implantation de particules lourdes telles que les ions. Dans le cadre de l'invention, on préférera notamment l'implantation d'ions fluorure.

On dépose ensuite sur toute la surface de la plaquette une couche de silicium amorphe 7 de manière à au moins combler les cavités latérales et l'évidemment au dessus de la tranchée 4. La couche amorphe 7 déposée a donc ici un rôle de liaison entre les régions 6 et 6bis ainsi que de rebouchage de la surface. Le dépôt de silicium amorphe se fait de manière classique à basse température. On peut par exemple utiliser un four LPCVD (dépôt chimique basse pression)en injectant du silane à température suffisamment faible, par exemple inférieure à 600°C, typiquement à 400°C. On obtient alors le dispositif illustré à la figure 1d, sur laquelle dans une tranchée 4 gravée dans un substrat 1, un bloc de silicium polycristallin 9 est partiellement enveloppé dans une couche d'oxyde de silicium 8. La hauteur de ce bloc, inférieure à celle de la tranchée 4, est également inférieure à la hauteur de l'enveloppe d'oxyde de silicium 8. Cet élément est surmonté d'une zone de silicium amorphe comportant les zones de silicium amorphisé 6 et 6bis et le silicium amorphe 7 déposé.

On effectue un recuit thermique de manière à restaurer la structure cristalline du silicium amorphe. Le recuit thermique permet de recristalliser le silicium amorphe en créant une ré-épitaxie du silicium amorphe 6, 7 à partir du silicium monocristallin du substrat initial 1. La restructuration du réseau de silicium monocristallin conduit à la figure 1e où la précédente couche de silicium amorphe se fond maintenant avec le silicium monocristallin du substrat 1.

Il convient de noter ici que selon l'invention, la zone 6 est spatialement limitée, et la frontière entre cette zone 6 et le substrat 1 est facilement localisée par l'implantation ionique. Cette frontière est par ailleurs une frontière « douce », c'est à dire que le passage de l'état Si monocristallin à l'état Si amorphe est très progressif. Ces caractéristiques conduisent à un bon rendement de recristallisation de la zone 6, et à une recristallisation sans défauts, que l'on peut difficilement obtenir avec une surface à recristalliser importante.

De plus l'amorphisation de la zone 6bis permet d'éviter une « remontée » de défauts cristallins dans la couche monocristalline à partir du silicium polycristallin.

On effectue ensuite un polissage mécano chimique s'arrêtant sur la couche d'oxyde de silicium 2 pour retirer la couche de silicium recristallisé en surface de la plaquette. On élimine ensuite de manière classique la couche d'oxyde de silicium 2. Puis, afin de planifier la surface, on soumet la plaquette à un ultime polissage mécano chimique.

Après les étapes d'égalisation de la surface du substrat, on obtient un substrat final 10 en silicium monocristallin illustré à la figure 1f, dont la surface monocristalline parfaitement plane et uniforme permet la croissance épitaxiale sans défaut de silicium monocristallin. L'épaisseur du substrat 10 au dessus de la tranchée est de l'ordre de 0,2 microns et est dopé P avec une concentration de dopants de l'ordre de 5.10¹⁴ at/cm³. Le substrat comporte par ailleurs une tranchée capacitive enterrée TRC, et constituée de silicium polycristallin 90 fortement dopé partiellement enveloppé d'une paroi d'oxyde de silicium 8 le séparant latéralement du substrat 1. Au-dessus de cette tranchée capacitive enterrée et dans le substrat 1, il subsiste une zone dopée 1bis, de même conductivité que le silicium polycristallin 90. Cette zone correspond à la zone de silicium polycristallin amorphisée 6bis ainsi qu'à la partie de silicium 7 dopée par diffusion des dopants lors du recuit.

La destruction localisée selon l'invention du réseau cristallin avant sa restructuration, est particulièrement avantageuse pour des tranchées capacitives, car elle permet d'enterrer le silicium polycristallin 90 (toute la capacité) par une gravure contrôlée de l'oxyde de flanc 8, sans qu'il soit nécessaire de prévoir un oxyde supplémentaire.

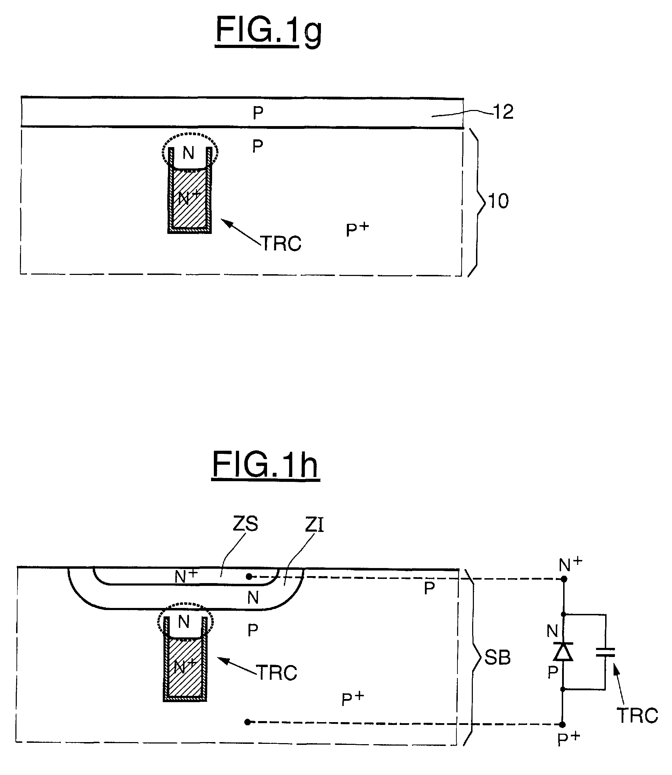

Le procédé se poursuit par une croissance épitaxiale sur la surface du substrat 10, d'une couche supérieure de substrat 12, formée de silicium dopé P (figure 1g), et ayant une épaisseur de deux microns environ. C'est dans cette couche 12 que va être réalisé la jonction.

Plus précisément, comme illustré sur la figure 1h, le substrat SB, formé du substrat 10 et de la couche 12, incorpore la tranchée capacitive TRC et la jonction. La zone supérieure 1bis de la tranchée vient au contact direct de la zone inférieure ZI dopée N de la jonction P/N.

Cette zone inférieure ZI est obtenue par exemple par implantation de phosphore avec une concentration de 3.10¹⁵ at/cm² environ à une énergie de 100keV environ. La région N de la jonction comporte par ailleurs une zone supérieure ZS de type N plus fortement dopée que la zone inférieure ZI. A titre indicatif cette zone ZS est réalisée par implantation d'arsenic avec une concentration de 5.10¹⁵ at/cm² environ à une énergie de 60keV environ.

La co-diffusion des dopants est obtenue par un recuit thermique par exemple à une température de 1000°C pendant 20 minutes.

La partie droite de la figure 1h, représente le schéma électrique équivalent de la photodiode sur lequel on voit que la tranchée capacitive est connectée en parallèle avec la jonction P/N.

La collecte et le traitement des porteurs générés s'effectue de manière classique et connue en soi, par exemple avec un transistor MOS ou bien un dispositif à transfert de charges (Dispositif CCD).

Il convient également de noter qu'en cas de matriçage de cette photodiode, la présence des tranchées enterrées ne crée pas de zone non sensible à la lumière.

## Revendications

1. Circuit intégré, comprenant un substrat incorporant un dispositif semiconducteur du type photodiode comportant une jonction P/N, **caractérisé par le fait que** le dispositif comporte au moins une tranchée capacitive enterrée dans le substrat et connectée en parallèle avec ladite jonction.

2. Circuit selon la revendication 1, **caractérisé par le fait que** le substrat est formé de silicium, **par le fait que** la tranchée capacitive comporte une zone interne de silicium dopé, partiellement enveloppée d'une paroi isolante séparant latéralement ladite zone interne du substrat, et surmontée d'une zone supérieure de silicium dopé, cette zone supérieure étant en contact avec ladite jonction.

3. Circuit selon la revendication 2, **caractérisé par le fait que** le substrat comporte une partie inférieure fortement dopée avec une conductivité de type P et une partie supérieure de conductivité P moins dopée que la partie inférieure, **par le fait que** la zone interne et la zone supérieure de la tranchée capacitive ont une conductivité de type N, et **par le fait que** la région de la jonction ayant la conductivité de type N, comporte une zone inférieure de conductivité N en contact avec la zone supérieure de la tranchée, et une zone supérieure de conductivité N mais plus fortement dopée que la zone inférieure.

4. Procédé de fabrication d'un circuit intégré comprenant un substrat incorporant un dispositif semiconducteur du type photodiode comportant une jonction P/N, **caractérisé par le fait que** :
a) on élabore un substrat initial monocristallin (1) présentant localement une tranchée capacitive débouchant à la surface du substrat initial et formant une discontinuité du réseau cristallin,
b) on évide le substrat initial au niveau de la tranchée,
c) on amorphise le réseau cristallin en périphérie de l'évidemment,
d) on dépose sur la structure obtenue à l'étape précédente une couche de matière amorphe ayant la même composition chimique que celle du substrat initial,
e) on effectue un recuit thermique de la structure obtenue à l'étape précédente afin de recristalliser la matière amorphe en continuité avec le réseau monocristallin du substrat initial,
f) on fait croître par épitaxie une couche supérieure de substrat dans laquelle on réalise ladite jonction connectée en parallèle avec ladite tranchée capacitive.

5. Procédé selon la revendication 4, **caractérisé par le fait qu'**il comprend, préalablement ou postérieurement à l'étape e), une étape d'aplanissement de surface.

6. Procédé selon la revendication 5, **caractérisé par le fait que** l'étape d'aplanissement comporte un polissage mécano-chimique.

7. Procédé selon l'une des revendications 4 à 6, **caractérisé par le fait que** l'étape d'amorphisation comporte une implantation ionique localisée autour de l'évidemment par une opération de masquage.

8. Procédé selon l'une des revendications 4 à 7, **caractérisé par le fait que** dans l'étape a), on dépose successivement sur le substrat initial (1) une première couche (2) d'un premier matériau et une deuxième couche (3) d'un deuxième matériau, puis on grave une tranchée (4) que l'on remplit avec un matériau de remplissage,
et **par le fait que** dans l'étape b), on effectue une gravure sélective vis-à-vis de ladite deuxième couche (3), de la première couche et d'une partie supérieure du matériau de remplissage de la tranchée, de façon à former des cavités latérales et ledit évidemment au niveau de la discontinuité cristalline, et on retire ladite deuxième couche (2).

9. Procédé selon la revendication 8, **caractérisé en ce que** dans l'étape a), le remplissage de la tranchée comprend les étapes suivantes :
- on tapisse les parois de la tranchée (4) avec de l'oxyde (8) par oxydation thermique ;
- on dépose du silicium polycristallin (9) fortement dopé dans la tranchée (4) de manière à la remplir ;
- on grave le silicium polycristallin (9) déposé précédemment de manière à ce que le niveau de remplissage de la tranchée (4) soit en dessous de la surface du substrat initial (1).

10. Procédé selon l'une des revendications 4 à 9, **caractérisé par le fait que** la formation de la jonction comporte une co-diffusion de surface de type N⁺ avec de l'arsenic et du phosphore.
